# EUROPEAN PATENT SPECIFICATION

(11) **EP 4 325 627 B1**
(45) Date of publication and mention of the grant of the patent: **21.10.2026**
(21) Application number: 21839810.5
(22) Date of filing: 14.04.2021
(51) Int. Cl.: H01M 10/48, B60L 3/00, G01M 17/007, G01R 31/392, H01M 10/42, G01R 31/396, H01M 10/613, H01M 10/625, H01M 50/209, H01M 50/20, H01M 10/6563, H01M 50/569, H01M 50/317

(54) **THERMAL CHAIN REACTION DETERMINATION METHOD AND THERMAL CHAIN REACTION DETECTION SYSTEM FOR BATTERY PACK**
VERFAHREN ZUR BESTIMMUNG EINER WÄRMEKETTENREAKTION UND SYSTEM ZUR ERKENNUNG EINER WÄRMEKETTENREAKTION FÜR EIN BATTERIEPACK
PROCÉDÉ DE DÉTERMINATION DE RÉACTION DE CHAÎNE THERMIQUE ET SYSTÈME DE DÉTECTION DE RÉACTION DE CHAÎNE THERMIQUE POUR BLOC-BATTERIE

(43) Date of publication of application: 21.02.2024
(73) Proprietor: NISSAN MOTOR CO., LTD., Yokohama-shi, Kanagawa 221-0023 (JP)
(72) Inventor: TAGUCHI, Hiromoto, Atsugi-shi Kanagawa 2430123 (JP); MATSUYAMA, Ayuka, Atsugi-shi Kanagawa 2430123 (JP); KASEDO, Kohei, Atsugi-shi Kanagawa 2430123 (JP); YANG, Qiye, Atsugi-shi Kanagawa 2430123 (JP); ZHOU, Xubin, Atsugi-shi Kanagawa 2430123 (JP); KOBAYASHI, Tomokazu, Atsugi-shi Kanagawa 2430123 (JP); MIYAKE, Ko, Atsugi-shi Kanagawa 2430123 (JP); OGAWA, Hiroshi, Atsugi-shi Kanagawa 2430021 (JP)
(74) Representative: Grünecker Patent- und Rechtsanwälte PartG mbB
(86) International application number: PCT/JP2021/015496
(87) International publication number: WO 2022/219751

(56) References cited:
- CN-A- 112 034 358
- CN-A- 112 394 291
- DE-A1- 102021 105 865
- JP-A- 2011 060 755
- JP-A- 2020 087 865
- US-A1- 2016 018 472
- US-A1- 2019 356 023

## Description

The present invention relates to a thermal chain determination method and a thermal chain detection system for a battery pack.

In a battery pack containing a plurality of battery cells, when an abnormality such as an internal short circuit occurs in one battery cell, heat generated by this battery cell may cause heat generated by another battery cell, which may lead to a thermal chain (thermal runaway). Vehicles such as electric vehicles and hybrid vehicles on which a battery pack is mounted are required to include a system for detecting the thermal chain (thermal runaway) early and accurately in view of safety.

However, for example, when detecting the thermal chain by detecting a temperature, the thermal chain cannot be detected quickly since there is a time lag from an occurrence of an abnormality in one battery cell to a temperature rise inside the battery pack due to the thermal chain.

Regarding the above problem, JP2011-060755A discloses a system that detects a pressure in a battery pack and detects a thermal chain (thermal runaway) based on a change in the pressure in the battery pack. With this system, the thermal chain is detected based on the pressure, and thus the problem of time lag can be solved. Further examples of methods for detecting a thermal chain can be found in CN 112 034 358 A, US 2019/356023 A1, US 2016/018472 A1, and CN 112 394 291 A.

In recent years, there is an increasing number of battery packs including a cooling system using a gas refrigerant and an exhaust gas passage for battery cells that couples the battery cells and the outside of a battery pack. In such a battery pack, when the refrigerant gas leaks into the battery pack, the pressure in the battery pack rises regardless of the thermal chain. Further, the pressure in the battery pack may change regardless of the thermal chain due to an influence of the exhaust gas passage coupled to the outside of the battery pack as well. For such a battery pack including a pressure contributing component that contributes to a pressure change in the battery pack, it is not possible to accurately detect the occurrence of the thermal chain by only detecting the pressure in the battery pack as in the technique described in JP2011-060755A, and there is a risk of erroneously detecting the thermal chain.

The present invention is made in view of the above problems, and an object of the present invention is to provide a thermal chain determination method and a thermal chain detection system for a battery pack that are capable of quickly and accurately detecting an occurrence of thermal chain.

This is achieved by the features of the independent claims. Further features and advantages of the present invention are set forth in dependent claims.
FIG. 1 is a schematic configuration diagram showing a main configuration of a thermal chain detection system for a battery pack according to a first embodiment of the present invention.
FIG. 2 is a block diagram showing a control configuration of the thermal chain detection system.
FIG. 3 is a timing chart showing a thermal chain detection method.
FIG. 4 is a flowchart showing the thermal chain detection method.
FIG. 5 is a schematic configuration diagram showing a main configuration of a thermal chain detection system for a battery pack according to a second embodiment of the present invention.
FIG. 6 is a block diagram showing a control configuration of the thermal chain detection system according to the second embodiment.

Hereinafter, embodiments of the present invention are described with reference to the drawings and the like.

### <First Embodiment>

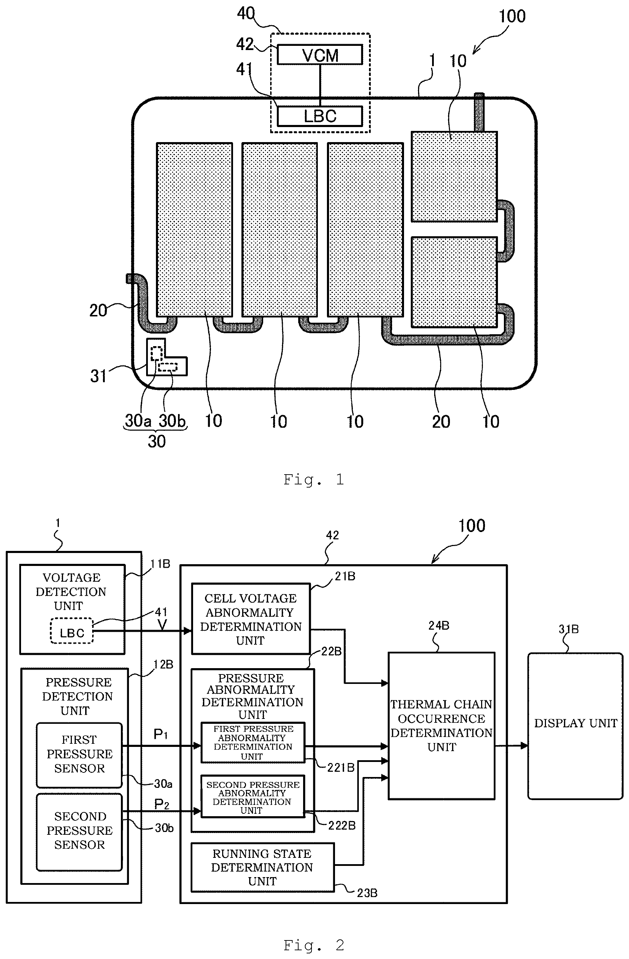

FIG. 1 is a schematic configuration diagram of a thermal chain detection system 100 for a battery pack (hereinafter, referred to as thermal chain detection system) according to the first embodiment of the present invention. The thermal chain detection system 100 is mounted on a vehicle such as an electric vehicle or a hybrid vehicle.

As shown in FIG. 1, the thermal chain detection system 100 includes a battery pack 1, a plurality of battery modules 10 housed in the battery pack 1, a refrigerant gas passage 20 that cools the battery modules 10, a plurality of pressure sensors 30 that detect a pressure in the battery pack 1, a controller 40, and the like. FIG. 1 is a cross-sectional view of the battery pack 1 as viewed from an upper surface direction. An upper surface of the battery pack 1 is covered with a cover portion although not shown. That is, the battery pack 1 is a so-called closed-type battery pack.

Each of the battery modules 10 is a cell stack (cells) formed by stacking a plurality of unit cells (not shown). The battery pack 1 houses the plurality of battery modules 10. The unit cells in the first embodiment are lithium ion secondary batteries, and are not necessarily limited thereto. Although not shown, the battery modules 10 are electrically connected to an external load by a lead wire or the like, and the battery modules 10 are also electrically connected to each other by a lead wire or the like. The number and an arrangement of the battery modules 10 in the battery pack 1 are optional and are not limited to those shown in FIG. 1.

The refrigerant gas passage 20 is a passage through which a refrigerant gas for cooling the battery modules 10 circulates and passes through each battery module 10. When the refrigerant gas leaks into the battery pack 1 from the refrigerant gas passage 20, the pressure in the battery pack 1 increases. That is, the refrigerant gas passage 20 is a pressure contributing component that contributes to a pressure change in the battery pack 1. In addition, the shape and the arrangement of the refrigerant gas passage 20 are not limited to those of FIG. 1 as long as the refrigerant gas passage 20 is capable of cooling the battery pack 1.

The pressure sensors 30 include a first pressure sensor 30a and a second pressure sensor 30b and detect a pressure P in the battery pack 1. The pressure sensors 30 are provided below a shielding plate 31 made of a metal plate or the like, and pressure measuring units of the pressure sensors 30 are directed at a bottom direction of the battery pack 1. By covering the pressure sensors 30 with the shielding plate 31 in this way, the pressure sensors 30 are protected by the shielding plate 31 even when a thermal chain, which will be described later, occurs in the battery pack and a high-temperature and high-pressure gas is ejected from the cells. That is, since the pressure sensors 30 are provided at a position where the pressure sensors 30 would not be affected by the thermal chain when the thermal chain occurs, the pressure sensors 30 operate normally even when the thermal chain occurs. The pressure P detected by the pressure sensors 30 is transmitted to the controller 40 described later.

The controller 40 is constituted by a computer including a central processing unit (CPU), a read-only memory (ROM), a random access memory (RAM), and an input and output interface (I/O interface), and performs an integrated control of the thermal chain detection system 100. The controller 40 may also be constituted by a plurality of microcomputers. The controller 40 controls the thermal chain detection system 100 by executing a specific program. The controller 40 executes, for example, a thermal chain detection control described later.

The controller 40 includes a battery controller (LBC) 41 and a vehicle control module (VCM) 42. The LBC 41 and the VCM 42 are connected to each other in a communicable manner by a CAN that is a communication line or the like.

The LBC 41 is provided in the battery pack 1 and is electrically connected to each battery module 10. The LBC 41 includes a plurality of voltage sensors that measure a voltage V of the cells of the battery modules 10 (hereinafter, referred to as voltage of the battery modules 10 or cell voltage). The cell voltage V acquired by the LBC is transmitted to the VCM 42.

The VCM 42 controls an entire system of the vehicle on which the thermal chain detection system 100 is mounted. As will be described later, the VCM 42 determines, for example, whether the acquired pressure P in the battery pack 1 and the cell voltage V are abnormal, and determines whether the thermal chain occurs in the battery pack 1.

In a battery pack housing a plurality of cells like the battery pack 1, when an abnormality such as an internal short circuit occurs in one cell, heat generated by this cell may cause heat generated by another cell, which may lead to the thermal chain (thermal runaway). Therefore, vehicles on which a battery pack is mounted are required to include a system for detecting the thermal chain (thermal runaway) early and accurately in view of safety (for example, EVS-GTR or the like).

However, for example, when the thermal chain is detected by detecting a temperature, the thermal chain cannot be detected quickly since there is a time lag from an occurrence of an abnormality in one cell to a temperature rise in the battery pack due to the thermal chain.

In a system that detects a pressure in a battery pack and detects the thermal chain based on a change in the pressure in the battery pack, the problem of time lag may be solved. However, in a battery pack that includes a cooling system (refrigerant gas passage 20) using a gas refrigerant as in the first embodiment, when a refrigerant gas leaks into the battery pack, the pressure inside the battery pack rises regardless of the thermal chain. Further, for example, in a battery pack that includes a gas discharge passage for discharge an exhaust gas of battery cells that couples the battery cells and the outside of the battery pack, the pressure in the battery pack may change regardless of the thermal chain due to an influence of the gas discharge passage coupled to the outside of the battery pack as well. For such a battery pack including the pressure contributing component that contributes to the pressure change in the battery pack, it is not possible to accurately detect the occurrence of the thermal chain by only detecting the pressure in the battery pack, and there is a risk of erroneously detecting the thermal chain.

Therefore, in the first embodiment, when both the pressure P in the battery pack 1 and the cell voltage V in the battery pack are abnormal, it is determined that the thermal chain occurs. Therefore, even when the pressure P in the battery pack 1 becomes abnormal due to the pressure contributing component that contributes to the pressure change in the battery pack, such as the refrigerant gas passage 20, it is not determined that the thermal chain occurs unless the voltage V of the battery module 10 is abnormal. Further, since the occurrence of the thermal chain is determined based on the pressure P and the voltage V, the thermal chain can be detected quickly. That is, the occurrence of the thermal chain can be detected quickly and accurately.

In addition, with improvement in safety of cells in recent years, there are many cases where no thermal chain is caused even when the cell voltage is abnormal due to the internal short circuit or the like, except that there is a risk of erroneously detecting the thermal chain by only detecting the cell voltage. In response to the above problem, in the first embodiment, it is determined that the thermal chain occurs only when both the pressure P in the battery pack 1 and the cell voltage V are abnormal, and thus the erroneous detection is prevented.

FIG. 2 is a block diagram showing a control configuration of the thermal chain detection system 100.

As shown in FIG. 2, the thermal chain detection system 100 includes a voltage detection unit 11B and a pressure detection unit 12B in the battery pack 1, a cell voltage abnormality determination unit 21B, a pressure abnormality determination unit 22B, a running state determination unit 23B and a thermal chain occurrence determination unit 24B that are a part of the VCM 42, and a display unit 31B.

The voltage detection unit 11B is constituted by the LBC 41 including the voltage sensors for measuring the cell voltage V of the battery modules 10. The cell voltage V detected by the LBC 41 is input to the cell voltage abnormality determination unit 21B of the VCM 42 at predetermined time intervals or at all times.

The pressure detection unit 12B is constituted by the first and second pressure sensors 30a and 30b that detect the pressure P in the battery pack 1. A pressure P₁ detected by the first pressure sensor 30a is input to a first pressure abnormality determination unit 221B and a pressure P₂ detected by the second pressure sensor 30b is input to a second pressure abnormality determination unit 222B of the VCM 42 at predetermined time intervals or at all times, respectively.

The cell voltage abnormality determination unit 21B determines whether the cell voltage V input from the voltage detection unit 11B is abnormal. Specifically, the cell voltage abnormality determination unit 21B determines whether an amount of change or a rate of change ΔV (hereinafter, referred to as the amount (rate) of change ΔV) in the cell voltage V input at the predetermined time intervals or at all times is larger than a predetermined value ΔVₜₕ, and whether an absolute value of the cell voltage V is smaller than a predetermined value Vth. When the amount (rate) of change ΔV is larger than the predetermined value ΔVₜₕ, or when the absolute value of the cell voltage V is smaller than the predetermined value Vₜₕ, the cell voltage abnormality determination unit 21B determines that the cell voltage V is abnormal. The predetermined value ΔVₜₕ here is, for example, a value of the amount (rate) of change in the voltage by which the cells can be regarded as being over-discharged. Similarly, the predetermined value Vₜₕ is a value by which the cells can be regarded as being over-discharged when the absolute value of the cell voltage V is smaller than the Vₜₕ. The predetermined value ΔVₜₕ or Vₜₕ can be set in advance based on experiments, common technical knowledge and the like.

The cell voltage abnormality determination unit 21B determines that the cell voltage V is abnormal even when the internal short circuit is detected based on the input cell voltage V, when the cell voltage V is an invalid value, or when communication between the LBC 41 and the VCM 42 is poor. When the internal short circuit in one cell is detected, the cell is in an over-discharged state. When an abnormality occurs in the cells due to the thermal chain and an abnormality such as damage occurs in the voltage sensors, the cell voltage V is an invalid value. When an abnormality occurs in the cells due to the thermal chain and an abnormality such as damage occurs in the LBC 41 or the communication line CAN or the like between the LBC 41 and the VCM 42, the communication between the LBC 41 and VCM 42 is poor. In such a case, the cell voltage abnormality determination unit 21B determines that the cell voltage V is abnormal by regarding the amount (rate) of change ΔV in the cell voltage V as larger than the predetermined value ΔVₜₕ, or regarding the absolute value of the cell voltage V as smaller than the predetermined value Vₜₕ.

The cell voltage abnormality determination unit 21B determines that the cell voltage V is abnormal when at least one cell voltage V of the battery modules 10 is abnormal. For example, when it is assumed that the cell voltage V is determined to be abnormal only when values of all the voltage sensors of the LBC 41 are abnormal, there is a risk that the abnormality in the cell voltage V is not detected when a part of the voltage sensors of LBC 41 are faulty, or when a part of the cell voltages are not detected accurately for a certain reason. In such a case, there is a risk that the occurrence of the thermal chain cannot be detected. In response to the above problem, in the first embodiment, since it is determined that the cell voltage V is abnormal when at least one cell voltage V is abnormal, the thermal chain can also be detected when a part of the voltage sensors are faulty.

Since the VCM 42 including the cell voltage abnormality determination unit 21B is provided outside the battery pack 1, the VCM 42 is not affected by the high-temperature and high-pressure gas ejected from the cells even when the thermal chain occurs. Therefore, even when the abnormality such as damage occurs in the voltage detection unit 11B (LBC 41) or the communication line between the LBC 41 and the VCM 42 due to the high-temperature and high-pressure gas during the thermal chain, the VCM 42 can detect the poor communication with the LBC 41. That is, for example, even when the LBC 41 or the like is damaged due to the thermal chain, the VCM 42 can detect the abnormality of the cell voltage V.

When the cell voltage abnormality determination unit 21B determines that the cell voltage V is abnormal, a signal indicating that the cell voltage is abnormal is input from the cell voltage abnormality determination unit 21B to the thermal chain occurrence determination unit 24B.

The pressure abnormality determination unit 22B is constituted by the first pressure abnormality determination unit 221B and the second pressure abnormality determination unit 222B, and determines whether the pressure P in the battery pack 1 input from the pressure detection unit 12B is abnormal.

The pressure P₁ detected by the first pressure sensor 30a is input to the first pressure abnormality determination unit 221B and the pressure P₂ detected by the second pressure sensor 30b is input to the second pressure abnormality determination unit 222B at the predetermined time intervals or at all times, respectively.

The first pressure abnormality determination unit 221B and the second pressure abnormality determination unit 222B determine whether amounts of change or rates of change ΔP (hereinafter, referred to as the amount (rate) of change ΔP) of the pressures P₁ and P₂ that are input at the predetermined time intervals or all the times are larger than a predetermined value ΔPₜₕ. The predetermined value ΔPₜₕ here is a value corresponding to, for example, the amount of change or the rate of change in the pressure when the thermal chain occurs, and can be set in advance based on experiments, common technical knowledge and the like. The first pressure abnormality determination unit 221B and the second pressure abnormality determination unit 222B respectively determine that the pressures P₁ and P₂ are abnormal when the amounts (rates) of change ΔP of the input pressures P₁ and P₂ are larger than the predetermined value ΔPₜₕ. When the first pressure abnormality determination unit 221B or the second pressure abnormality determination unit 222B determines that the pressure is abnormal, a signal indicating that the pressure P in the battery pack 1 is abnormal is input from the pressure abnormality determination unit 22B to the thermal chain occurrence determination unit 24B.

In this way, when at least one of the first pressure abnormality determination unit 221B and the second pressure abnormality determination unit 222B determines that the pressure is abnormal, the signal indicating that the pressure P is abnormal is input to the thermal chain occurrence determination unit 24B. Therefore, even when one of the pressure sensors 30a and 30b is faulty, or when the pressure is not detected accurately for a certain reason, the abnormality of the pressure P in the battery pack 1 can be detected. Therefore, the thermal chain also can be detected when one of the pressure sensors 30a and 30b is faulty.

The running state determination unit 23B determines whether the vehicle is in a running state or a stopped state based on an accelerator operation of a driver or the like. A determination result of the running state determination unit 23B is input to the thermal chain occurrence determination unit 24B.

When receiving the signals indicating abnormality occurrence from both the cell voltage abnormality determination unit 21B and the pressure abnormality determination unit 22B, the thermal chain occurrence determination unit 24B determines that the thermal chain occurs. That is, the thermal chain occurrence determination unit 24B determines that the thermal chain occurs only when both the pressure P in the battery pack and the cell voltage V are abnormal. The signal indicating abnormality occurrence input from the pressure abnormality determination unit 22B here is a signal indicating abnormality occurrence input from either or both of the first pressure abnormality determination unit 221B and the second pressure abnormality determination unit 222B. Therefore, the thermal chain occurrence determination unit 24B determines that the thermal chain occurs when the cell voltage V and at least one of the pressures P₁ and P₂ in the battery pack are abnormal.

When the thermal chain occurrence determination unit 24B determines that the thermal chain occurs, a warning command is transmitted from the thermal chain occurrence determination unit 24B to the display unit 31B. In this case, the thermal chain occurrence determination unit 24B transmits the warning command to the display unit 31B together with a determination result input from the running state determination unit 23B.

The display unit 31B is, for example, a meter display provided on a dashboard of the vehicle, or the like. When receiving the warning command from the thermal chain occurrence determination unit 24B, the display unit 31B notifies the occurrence of the thermal chain of and issues a warning to occupants and the like. When the determination result of the running state determination unit 23B is the running state of the vehicle, the display unit 31B displays on a display, for example, the notification of the occurrence of the thermal chain and a warning urging to stop the vehicle and retreat to a safe place outside the vehicle to the occupants and the like. When the determination result of the running state determination unit 23B is the stopped state of the vehicle, the display unit 31B displays on the display, for example, the notification of the occurrence of the thermal chain and a warning urging to retreat to a safe place outside the vehicle to the occupants and the like. A method for notifying the occurrence of the thermal chain and warning is not limited to the display on the display, and may be performed by, for example, a voice of a speaker.

As described above, since the thermal chain detection system 100 detects the occurrence of the thermal chain based on the pressure P in the battery pack 1 and the cell voltage V, the thermal chain can be detected quickly. Further, it is determined that the thermal chain occurs when both the pressure P in the battery pack 1 and the cell voltage V are abnormal, and thus the erroneous detection on the occurrence of the thermal chain can be prevented.

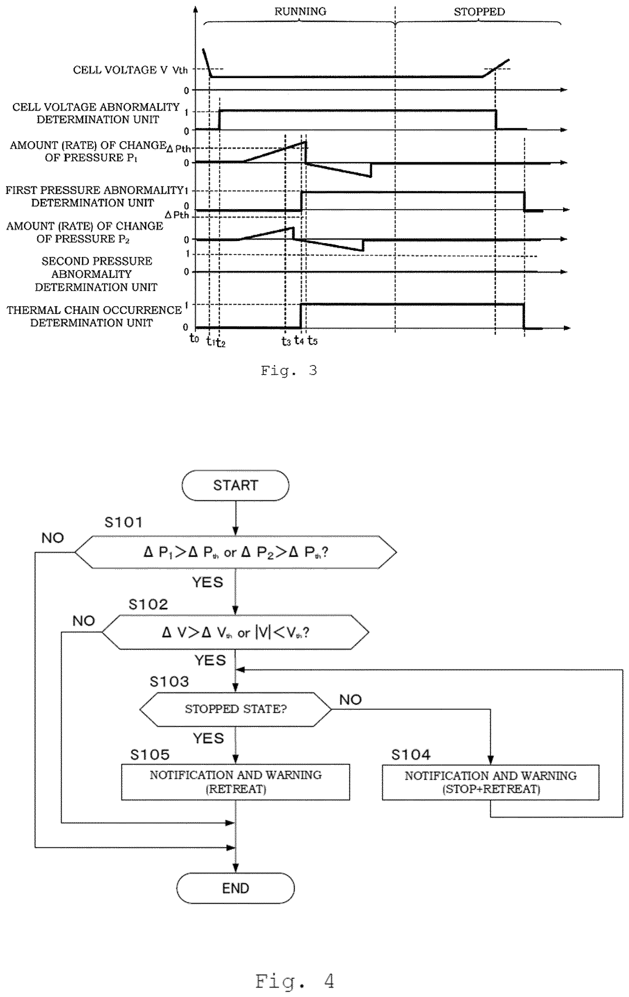

FIG. 3 is a timing chart showing a thermal chain detection method.

When the vehicle on which the thermal chain detection system 100 is mounted (hereinafter, simply referred to as the vehicle) is running, the cell voltage V is equal to or larger than the predetermined value Vₜₕ from a time point t₀ to a time point t₁, and the amounts (rates) of change ΔP₁ and ΔP₂ of the pressures P₁ and P₂ detected by the first pressure sensor 30a and the second pressure sensor 30b are both equal to or less than the predetermined value ΔPₜₕ. In such a case, the cell voltage abnormality determination unit 21B, the pressure abnormality determination unit 22B, and the thermal chain occurrence determination unit 24B all maintain abnormality flags (0: normal, 1: abnormal) at 0 (normal).

When the cell voltage V lowers below the predetermined value Vₜₕ that is a criteria for over-discharging at the time point t₁, the cell voltage abnormality determination unit 21B sets the abnormality flag of the cell voltage to 1 (abnormal) at a time point t₂ immediately after the time point t₁. A reason why the abnormality flag is set to 1 (abnormal) at the time point t₂ instead of the time point t₁ is to avoid determining the cell voltage V as abnormal when the cell voltage V momentarily lowers below the predetermined value Vₜₕ for a certain reason. In other word, when the cell voltage V returns to the predetermined value Vₜₕ or more between the time point t₁ and the time point t₂, the cell voltage abnormality determination unit 21B maintains the abnormality flag at 0 (normal).

When the abnormality flag is set to 1 (abnormal) at the time point t₂, the cell voltage abnormality determination unit 21B maintains the abnormality flag at 1 (abnormal) while the cell voltage V is lower than the predetermined value Vₜₕ.

The cell voltage abnormality determination unit 21B also sets the abnormality flag of the cell voltage to 1 (abnormal) when the internal short circuit is detected based on the cell voltage V, the cell voltage V is an invalid value, or the communication between the LBC 41 and the VCM 42 is poor.

At a time point t₃, when the amount (rate) of change ΔP₁ of the pressure P₁ detected by the first pressure sensor 30a exceeds the predetermined value ΔPₜₕ, the first pressure abnormality determination unit 221B sets the abnormality flag of the pressure P₁ to 1 (abnormal) at a time point t₄ after a predetermined time from the time point t₃. The predetermined time here is a time during which the pressure in the battery pack 1 can be confirmed to be not changed accidentally only for a short time, and can be set in advance by experiments or the like. The erroneous detection of pressure abnormality is prevented by setting the abnormality flag to 1 (abnormal) at the time point t₄ after the predetermined time from the time point t₃.

The thermal chain occurrence determination unit 24B sets the abnormality flag to 1 (abnormal) when the abnormality flags of the cell voltage abnormality determination unit 21B and the first pressure abnormality determination unit 221B become 1 (abnormal) at the time point t₄. That is, the thermal chain is detected.

The abnormality flag becomes 0 at a time point t₅ after the amount (rate) of change ΔP₁ of the pressure P₁ detected by the first pressure sensor 30a exceeds the predetermined value ΔPₜₕ, and then the amount (rate) of change ΔP₁ decreases to a negative value (the pressure decreases). That is, after the time point t₅, the amount (rate) of change ΔP₁ of the pressure P₁ is equal to or less than the predetermined value ΔPₜₕ. On the other hand, the first pressure abnormality determination unit 221B maintains the abnormality flag at 1 (abnormal) and continues an abnormality determination state for a predetermined time even when the amount (rate) of change ΔP₁ of the pressure P₁ becomes equal to or less than the predetermined value ΔPₜₕ after the abnormality flag is set to 1 (abnormal) at the time point t₄. That is, the abnormality flag is maintained at 1 (abnormal) even after t₅. In this way, the pressure abnormality determination unit 22B (the first pressure abnormality determination unit 221B) continues the pressure abnormality determination state for a predetermined time even when the amount (rate) of change ΔP in the pressure P in the battery pack 1 becomes equal to or less than the predetermined value Pₜₕ after the pressure P in the battery pack 1 is determined to be abnormal. Therefore, the thermal chain also can be detected when the pressure P in the battery pack 1 is reduced in a short time after the thermal chain occurs. The predetermined time here is a time during which it can be confirmed that no thermal chain occurs, and can be set in advance by experiments or the like.

When the abnormality flag of the thermal chain occurrence determination unit 24B becomes 1 (abnormal) at the time point t₄, the notification of the occurrence of the thermal chain and the warning urging to stop the vehicle and retreat to a safe place outside the vehicle to the occupants and the like are performed at the same time by display on the meter display or the like.

When the vehicle is in the stopped state at the time point t₅, the display on the meter display or the like is switched to the notification of the occurrence of the thermal chain and the warning urging to retreat to a safe place outside the vehicle to the occupants and the like.

Although the case where the amount (rate) of change ΔP₁ of the pressure P₁ detected by the first pressure sensor 30a exceeds the predetermined value ΔPₜₕ is described in FIG. 3, the same thermal chain detection method can be used when the amount (rate) of change ΔP₂ of the pressure P₂ detected by the second pressure sensor 30b exceeds the predetermined value ΔPₜₕ. That is, when the amount (rate) of change ΔP₂ of the pressure P₂ exceeds the predetermined value ΔPₜₕ, the second pressure abnormality determination unit 222B sets the abnormality flag to 1 (abnormal). When the abnormality flags of the cell voltage abnormality determination unit 21B and the second pressure abnormality determination unit 222B become 1 (abnormal), the thermal chain occurrence determination unit 24B sets the abnormality flag to 1 (abnormal) and the thermal chain is detected.

Although the case where the absolute value of the cell voltage V lowers below the predetermined value Vₜₕ is described in FIG. 3, when the amount (rate) of change ΔV of the cell voltage V is larger than the predetermined value ΔVₜₕ, the cell voltage abnormality determination unit 21B similarly sets the abnormality flag to 1 (abnormal). Further, as described above, when the internal short circuit is detected based on the cell voltage V, when the cell voltage V is an invalid value, or when the communication between the LBC 41 and the VCM 42 is poor, the cell voltage abnormality determination unit 21B sets the abnormality flag to 1 (abnormal) by regarding the amount (rate) of change ΔV in the cell voltage V as larger than the predetermined value ΔVₜₕ, or regarding the absolute value of the cell voltage V as smaller than the predetermined value Vₜₕ.

FIG. 4 is a flowchart showing the thermal chain detection method of the battery pack 1. All of the following controls are repeatedly executed by the controller 40 at predetermined time intervals.

When the thermal chain detection system 100 is activated, for example, by pressing an ignition switch of the vehicle, the controller 40 starts a thermal chain detection control. From the start to the end of the thermal chain detection control, the controller 40 constantly acquires the pressures P₁ and P₂ in the battery pack 1 detected by the first and second pressure sensors 30a and 30b, the cell voltage V detected by the voltage sensors of the LBC 41, and information on the running state of the vehicle, or acquire these information at predetermined time intervals.

In step S101, the controller 40 determines whether the pressure P in the battery pack 1 is abnormal. The controller 40 determines whether the amount (rate) of change ΔP₁ of the pressure P₁ detected by the first pressure sensor 30a and the amount (rate) of change ΔP₂ of the pressure P₂ detected by the second pressure sensor 30b are larger than the predetermined value ΔPₜₕ. Then, the controller 40 determines that the pressure P in the battery pack 1 is abnormal when either or both of the amount (rate) of change ΔP₁ of the pressure P₁ and the amount (rate) of change ΔP₂ of the pressure P₂ are larger than the predetermined value ΔPₜₕ. The controller 40 determines that the pressure P is abnormal when the pressure P in the battery pack 1 is abnormal within a predetermined time. That is, when the amount (rate) of change ΔP of the pressure P in the battery pack 1 becomes larger than the predetermined value ΔPₜₕ, the controller 40 determines that the pressure P is abnormal within the predetermined time even when the amount (rate) of change ΔP of the pressure P subsequently becomes equal to or less than the predetermined value ΔPₜₕ.

When the pressure P in the battery pack 1 is abnormal, the controller 40 executes step S102. On the other hand, when the pressure P in the battery pack 1 is not abnormal, the controller 40 determines that no thermal chain occurs and ends the thermal chain detection control.

In step S102, the controller 40 determines whether the cell voltage V is abnormal. When the amount of change or the rate of change ΔV of the cell voltage V detected by the voltage sensors of the LBC 41 is larger than the predetermined value ΔVₜₕ, or the absolute value of the cell voltage V is smaller than the predetermined value Vₜₕ, the controller 40 determines that the cell voltage V is abnormal. The controller 40 may determine the abnormality of the cell voltage V based on both the amount (rate) of change ΔV of the cell voltage V and the absolute value of the cell voltage V, and may determine the abnormality of the cell voltage V based on one of the amount (rate) of change ΔV and the absolute value. Further, the controller 40 determines that the cell voltage V is abnormal when at least one cell voltage V detected by the voltage sensors of the LBC 41 is abnormal. When the cell voltage V is abnormal, the controller 40 determines that the occurrence of the thermal chain is detected, and executes step S103. On the other hand, when the cell voltage V is not abnormal, the controller 40 determines that no thermal chain occurs and ends the thermal chain detection control.

In step S103, the controller 40 determines whether the vehicle is in the stopped state based on the accelerator operation of the driver or the like. When the vehicle is in the running state, the controller 40 executes step S104. On the other hand, when the vehicle is in the stopped state, the controller 40 executes step S105.

When the vehicle is in the running state, in step S104, the controller 40 executes the notification of the occurrence of the thermal chain and the warning urging to stop the vehicle and retreat to a safe place outside the vehicle to the occupants and the like. The notification and the warning are executed by display on the meter display or the like. When the notification and the warning are executed, the controller 40 returns to step S103. In step S103, when the vehicle is still in the running state, the notification of the occurrence of the thermal chain and the warning urging to stop the vehicle and retreat to a safe place outside the vehicle are continued. On the other hand, when the vehicle is in the stopped state, the controller 40 executes step S105.

When the vehicle is in the stopped state in step S103, the controller 40 executes in step S105 the notification of the occurrence of the thermal chain and the warning urging to retreat to a safe place outside the vehicle to the occupants and the like. The notification and the warning are executed by display on the meter display or the like. When the notification and the warning are executed, the controller 40 ends the thermal chain detection control.

According to the thermal chain determination method and the thermal chain detection system 100 for the battery pack 1 of the first embodiment described above, the following effects can be achieved.

According to the thermal chain determination method for the battery pack 1, it is determined that the pressure P in the battery pack 1 is abnormal when the amount of change or the rate of change ΔP of the pressure P in the battery pack 1 is larger than the predetermined value ΔPₜₕ. When the amount of change or the rate of change ΔV of the cell voltage V is larger than the predetermined value ΔVₜₕ, or when the absolute value of the cell voltage V is smaller than the predetermined value Vₜₕ, it is determined that the cell voltage V is abnormal. Then, it is determined that the thermal chain occurs when both the pressure P in the battery pack 1 and the cell voltage V are abnormal. As a result, even when the pressure P in the battery pack 1 becomes abnormal due to the pressure contributing component that contributes to the pressure change in the battery pack 1, such as the refrigerant gas passage 20, it is not determined that the thermal chain occurs unless the voltage V of the battery module 10 is abnormal. Therefore, when the pressure P in the battery pack 1 changes regardless of the thermal chain, the erroneous detection of the occurrence of the thermal chain is prevented. Further, since the occurrence of the thermal chain is determined based on the pressure P in the battery pack 1 and the cell voltage V, the thermal chain can be detected quickly. That is, the occurrence of the thermal chain can be detected quickly and accurately.

Since it is determined that the thermal chain occurs when both the pressure P in the battery pack 1 and the cell voltage V are abnormal, the erroneous detection of the occurrence of the thermal chain is prevented when the cell voltage V is abnormal due to the internal short circuit or the like and the thermal chain does not occur.

According to the thermal chain determination method for the battery pack 1, the battery pack 1 includes a plurality of pressure sensors 30a and 30b. When the amount of change or the rate of change ΔP of the pressure in the battery pack 1 detected by at least one of the pressure sensors 30 is larger than the predetermined value ΔPₜₕ, it is determined that the pressure P in the battery pack 1 is abnormal. As a result, even when a part of the pressure sensors 30 are faulty, or when the value of the pressure P by a part of the pressure sensors 30 is not detected accurately for a certain reason, the abnormality of the pressure P in the battery pack 1 can be detected. Therefore, the thermal chain also can be detected when a part of the pressure sensors 30 are faulty.

According to the thermal chain determination method for the battery pack 1, the battery pack 1 includes a plurality of voltage sensors that detect the voltage V of different cells. In addition, when the amount of change or the rate of change ΔV of the cell voltage V detected by at least one of the voltage sensor is larger than the predetermined value ΔVₜₕ, or when the absolute value of the cell voltage V is smaller than the predetermined value Vₜₕ, it is determined that the cell voltage V is abnormal. As a result, even when a part of the voltage sensors are faulty, or when the value of the voltage V by a part of the voltage sensors is not detected accurately for a certain reason, the abnormality of the cell voltage V can be detected. Therefore, the thermal chain also can be detected when a part of the voltage sensors are faulty.

According to the thermal chain determination method for the battery pack 1, even when the amount of change or the rate of change ΔP of the pressure P in the battery pack 1 becomes equal to or less than the predetermined value ΔPₜₕ after the pressure P in the battery pack 1 is determined to be abnormal, the pressure abnormality determination state is continued for the predetermined time. Therefore, the thermal chain also can be detected when the pressure P in the battery pack 1 is reduced in a short time after the thermal chain occurs.

According to the thermal chain determination method for the battery pack 1, it is determined that the cell voltage V is abnormal in any one of the cases where the internal short circuit is detected based on the cell voltage V detected by the voltage sensor, where the cell voltage V detected by the voltage sensor is an invalid value, or where the communication between the battery controller (LBC) 41 and the vehicle controller (VCM) 42 is poor. That is, in these cases, it can be regarded that the amount of change or the rate of change ΔV of the cell voltage V is larger than the predetermined value ΔVₜₕ, or the absolute value of the cell voltage V is smaller than the predetermined value Vₜₕ. Therefore, the thermal chain can be detected more accurately in various scenes by determining that the cell voltage V is abnormal in such a case.

According to the thermal chain detection system 100 for the battery pack 1, the controller 40 determines that the thermal chain occurs when both the pressure P in the battery pack 1 and the cell voltage V are abnormal. Therefore, when the pressure P in the battery pack 1 changes regardless of the thermal chain, the erroneous detection of the occurrence of the thermal chain is prevented. Further, since the occurrence of the thermal chain is determined based on the pressure P in the battery pack 1 and the cell voltage V, the thermal chain can be detected quickly. That is, the occurrence of the thermal chain can be detected quickly and accurately.

According to the thermal chain detection system 100 for the battery pack 1, the controller 40 determines that the cell voltage V is abnormal in any one of the cases where the internal short circuit is detected, where the cell voltage V is an invalid value, or where the communication between the battery controller (LBC) 41 and the vehicle controller (VCM) 42 is poor. That is, in these cases, it can be regarded that the amount of change or the rate of change ΔV of the cell voltage V is larger than the predetermined value ΔVₜₕ, or the absolute value of the cell voltage V is smaller than the predetermined value Vₜₕ. Therefore, the thermal chain can be detected more accurately in various scenes by determining that the cell voltage V is abnormal in such a case.

According to the thermal chain detection system 100 for the battery pack 1, the pressure sensors 30 are provided at a position where the pressure sensors 30 would not be affected by the thermal chain in the battery pack 1 when the thermal chain occurs in the battery pack 1. Therefore, even when the thermal chain occurs in the battery pack 1, the pressure sensors 30 operate normally and can detect the change in the pressure P in the battery pack 1.

According to the thermal chain detection system 100 for the battery pack 1, the voltage sensors are provided in the battery pack 1, and the vehicle controller (VCM) 42 is provided outside the battery pack 1. As a result, even when the thermal chain occurs, the VCM 42 provided outside the battery pack 1 is not affected by the high-temperature and high-pressure gas ejected from the cells. Therefore, even when the abnormality such as damage occurs in the voltage detection unit 11B (LBC 41) or the communication line between the LBC 41 and the VCM 42 due to the high-temperature and high-pressure gas during the thermal chain, the VCM 42 can detect failure of communication with the LBC 41 and detect the abnormality in the cell voltage V. Therefore, for example, even when the voltage detection unit 11B (LBC 41) or the like is damaged by the thermal chain, the thermal chain can be detected.

Although the first embodiment has a configuration provided with two pressure sensors 30a and 30b, the number of pressure sensors 30 is optional and is not limited to two. It is preferable to provide a plurality of pressure sensors 30, and the configuration may be provided with only one pressure sensor 30. In such a case as well, it is determined that the thermal chain occurs when both the pressure P in the battery pack 1 and the cell voltage V are abnormal, and thus the erroneous detection of the occurrence of the thermal chain can be prevented. Further, for example, the configuration may be provided with three or more pressure sensors 30. In such a case, when the amount (rate) of change ΔP of the pressure P detected by at least one of the pressure sensors 30 is larger than the predetermined value ΔPₜₕ, it is determined that the pressure P in the battery pack 1 is abnormal.

As in the first embodiment, the pressure sensors 30 are preferably provided at a position where the pressure sensors 30 would not be affected by the thermal chain even when the thermal chain occurs. Alternatively, the present invention is not necessarily limited thereto, and the pressure sensors 30 may be provided anywhere in the battery pack 1.

In the first embodiment, the battery pack 1 is a closed-type battery pack. Alternatively, the present invention is not limited thereto, and the battery pack 1 may be an open-type battery pack whose upper portion is not covered with a cover portion.

In the first embodiment, the cell voltage abnormality determination unit 21B and the pressure abnormality determination unit 22B transmit a signal to the thermal chain occurrence determination unit 24B only in the case of the abnormality. Alternatively, the present invention is not limited thereto, and the cell voltage abnormality determination unit 21B and the pressure abnormality determination unit 22B may transmit a result of abnormality determination (that is, a signal indicating abnormality or normality). In this case, when determination results of the cell voltage abnormality determination unit 21B and the pressure abnormality determination unit 22B are both abnormal, the thermal chain occurrence determination unit 24B determines that the thermal chain occurs.

### <Second Embodiment>

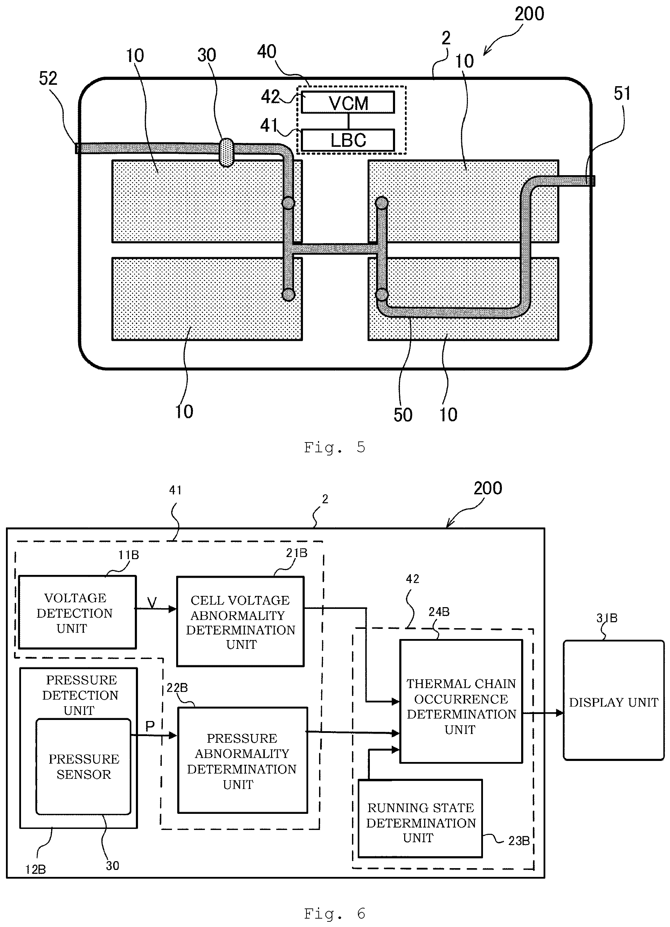

A thermal chain detection system 200 for a battery pack according to the second embodiment will be described with reference to FIGS. 5 and 6. The same elements as those in the first embodiment are denoted by the same reference numerals, and descriptions thereof will be omitted.

FIG. 5 is a schematic configuration diagram of the thermal chain detection system 200 according to the second embodiment. The second embodiment is different from the first embodiment in that a battery pack 2 is an open-type, a pressure contributing component is a gas discharge passage 50, and the like.

As shown in FIG. 5, the thermal chain detection system 200 includes the battery pack 2, the battery modules 10 in the battery pack 2, the gas discharge passage 50 through which an exhaust gas from cells constituting the battery module 10 flows, the controller 40, and the like. FIG. 5 is a cross-sectional view of the battery pack 2 as viewed from an upper surface direction, and an upper surface of the battery pack 2 is not covered. That is, the battery pack 2 is a so-called open-type battery pack.

The gas discharge passage 50 is a passage for discharging the exhaust gas of the cells, and is coupled to the battery modules 10 (cells) and the outside of the battery pack 2. An upstream end portion 51 of the gas discharge passage 50 is closed, and the exhaust gas from the cells flows toward a downstream end portion 52 of the gas discharge passage 50. The gas discharge passage 50 is coupled to one of the cells in the battery pack 2, and the gas discharge passage 50 downstream of the portion coupled to the cell is provided with a pressure sensor 30 that detects the pressure of the battery pack 2. In this way, since the gas discharge passage 50 is coupled to one of the cells and the pressure sensor 30 is downstream of the coupling portion, it is not necessary to provide the pressure sensor 30 for each cell, and the number of the pressure sensors can be reduced.

Similar to the first embodiment, the arrangement and the number of the battery modules 10 (cells) in the battery pack 2 are optional and are not limited to those in FIG. 5.

When there is a variation in the arrangement of the battery modules 10 (cells) in the battery pack 2, the position of the gas discharge passage 50 coupled to the cells also varies. However, in this case, a position variation absorption structure such as a bellows may be provided at a part of the gas discharge passage 50 to widen a movable range of the gas discharge passage 50. That is, the degree of freedom in layout of the battery modules 10 can be increased by providing the position variation absorption structure at the gas discharge passage 50.

Here, it is easier to detect a change in the pressure when the pressure sensor 30 is provided at a position closer to the battery modules 10 (cells) downstream of the coupling portion of the gas discharge passage 50. On the other hand, when the pressure sensor 30 is exposed to the high-temperature and high-pressure gas ejected from the cells when the thermal chain occurs, there is a risk of a defect such as a failure. Therefore, considering relations between a detection capability of the device and a pressure resistance and a heat resistance of the device, the pressure sensor 30 is arranged at a most appropriate position determined by tests, experiments and the like.

As the change in the pressure in the gas discharge passage 50 is more remarkable, the pressure sensor 30 detects the change in the pressure more easily. However, when the pressure in the gas discharge passage 50 is excessively high, the gas discharge passage 50 may be damaged. Therefore, considering the relation between the detection capability of the pressure sensor 30 and the pressure resistance of the gas discharge passage 50, an internal hydraulic diameter of the gas discharge passage 50 is adjusted to a most appropriate value determined by tests, experiments and the like.

The downstream end portion 52 of the gas discharge passage 50 is closed by an air-permeable membrane (not shown) that adjusts the pressure in the gas discharge passage 50. The air-permeable membrane is a pressure adjusting mechanism that adjusts the pressure in the gas discharge passage 50 by making air permeable or impermeable by a pressure difference between the inside and outside of the gas discharge passage 50. However, as in the case where the thermal chain occurs, when the pressure in the gas discharge passage 50 suddenly becomes high, the air-permeable membrane is deviated from the gas discharge passage 50 and is blown off. Further, the pressure adjusting mechanism is not limited to the air-permeable membrane, and may be any known member as long as the pressure in the gas discharge passage 50 can be adjusted.

The pressure P in the battery pack 2 detected by the pressure sensor 30 is transmitted to the LBC 41.

The controller 40 includes the LBC 41 and the VCM 42, and the LBC 41 and the VCM 42 are connected to each other in a communicable manner with the CAN that is a communication line or the like. In the second embodiment, since the battery pack 2 is an open-type, even when the LBC 41 and VCM 42 are arranged in the battery pack 2, the LBC 41 and the VCM 42 are not easily affected by the high-temperature and high-pressure gas ejected from the cells when the thermal chain occurs. Therefore, both the LBC 41 and the VCM 42 are provided in the battery pack 2. As a result, the thermal chain detection system 100 is made compact.

The LBC 41 includes a plurality of voltage sensors (not shown) for measuring the cell voltage V of the battery modules 10. In addition, the LBC 41 determines whether the pressure P in the battery pack 2 received from the pressure sensor 30 and the voltage V of the battery modules 10 (cells) acquired by the voltage sensor are abnormal.

The VCM 42 controls an entire system of a vehicle. For example, the VCM 42 determines whether the thermal chain occurs in the battery pack 2 and transmits a command for displaying a notification of the occurrence of the thermal chain and a warning to the display unit 31B.

FIG. 6 is a block diagram showing a control configuration of the thermal chain detection system 200 for the battery pack according to the second embodiment.

As shown in FIG. 6, the thermal chain detection system 200 includes the voltage detection unit 11B, the pressure detection unit 12B, the cell voltage abnormality determination unit 21B, the pressure abnormality determination unit 22B, the running state determination unit 23B and the thermal chain occurrence determination unit 24B in the battery pack 2, and the display unit 31B. In the second embodiment, the voltage detection unit 11B, the cell voltage abnormality determination unit 21B and the pressure abnormality determination unit 22B constitute a part of the LBC 41, and the running state determination unit 23B and the thermal chain occurrence determination unit 24B constitute a part of the VCM 42.

The voltage detection unit 11B includes voltage sensors for measuring the cell voltage V of the cells, which are included in the LBC 41. The cell voltage V detected by the voltage sensors is input to the cell voltage abnormality determination unit 21B at predetermined time intervals or at all times.

The pressure detection unit 12B is constituted by the pressure sensor 30 that detects the pressure P in the battery pack 2. The pressure P in the battery pack 2 detected by the pressure sensor 30 is input to the pressure abnormality determination unit 22B of the LBC 41 at predetermined time intervals or at all times.

The cell voltage abnormality determination unit 21B determines whether the cell voltage V input from the voltage detection unit 11B is abnormal. The specific determination method is the same as that of the first embodiment and the like, and thus the descriptions are omitted.

When the cell voltage abnormality determination unit 21B determines that the cell voltage V is abnormal, a signal indicating that the cell voltage is abnormal is input from the cell voltage abnormality determination unit 21B to the thermal chain occurrence determination unit 24B.

The pressure abnormality determination unit 22B determines whether the pressure P in the battery pack 2 input from the pressure detection unit 12B is abnormal. The specific determination method is the same as that of the first embodiment, and thus the descriptions are omitted.

When the pressure P in the battery pack 2 becomes high, the air-permeable membrane (pressure adjusting mechanism) that closes the downstream end portion 52 of the gas discharge passage 50 is deviated, and the pressure P is almost constant after the pressure in the gas discharge flow path 50 is reduced. Therefore, even when the amount (rate) of change ΔP of the pressure P in the battery pack 2 becomes equal to or less than the predetermined value ΔPₜₕ after the pressure P in the battery pack 2 is determined to be abnormal, the pressure abnormality determination unit 22B continues a pressure abnormality determination state for a predetermined time. As a result, even when the ΔP lowers below the predetermined value ΔPₜₕ due to an action of the pressure adjusting mechanism after the amount (rate) of change ΔP of the pressure P in the battery pack 2 becomes larger than the predetermined value ΔPₜₕ, the pressure P can be detected as abnormal.

The running state determination unit 23B determines whether the vehicle is in a running state or a stopped state based on an accelerator operation of a driver or the like. A determination result of the running state determination unit 23B is input to the thermal chain occurrence determination unit 24B.

When receiving input signals indicating abnormality occurrence from both the cell voltage abnormality determination unit 21B and the pressure abnormality determination unit 22B, the thermal chain occurrence determination unit 24B determines that the thermal chain occurs, and transmits a warning command to the display unit 31B. Similar to the first embodiment, in this case, the thermal chain occurrence determination unit 24B transmits the warning command to the display unit 31B together with the determination result input from the running state determination unit 23B.

When receiving the warning command from the thermal chain occurrence determination unit 24B, the display unit 31B notifies the occurrence of the thermal chain of and issues a warning to occupants and the like. A method for notifying and warning is the same as that of the first embodiment, and thus the descriptions are omitted.

According to the thermal chain determination method and the thermal chain detection system 200 for the battery pack 2 of the second embodiment described above, the following effects can be further achieved.

According to the thermal chain determination method for the battery pack 2, even when the amount of change or the rate of change ΔP of the pressure P becomes equal to or less than the predetermined value ΔPₜₕ after the pressure P in the battery pack 2 is determined to be abnormal, the pressure abnormality determination state is continued for a predetermined time. As a result, even when the amount of change or the rate of change ΔP of the pressure P in the battery pack 2 becomes equal to or less than the predetermined value ΔPₜₕ due to an action of the pressure adjusting mechanism or the like after the amount of change or the rate of change ΔP of the pressure P in the battery pack 2 becomes larger than the predetermined value ΔPₜₕ, the pressure P can be detected as abnormal. That is, the thermal chain can be detected accurately.

According to the thermal chain detection system 200, the gas discharge passage 50 that couples the battery modules 10 (cells) and the outside of the battery pack 2 is provided, and the gas discharge passage 50 includes the pressure adjusting mechanism that adjusts the pressure in the gas discharge passage 50. As a result, even when the pressure in the gas discharge passage 50 changes regardless of the thermal chain, the pressure in the gas discharge passage 50 is adjusted by the pressure adjusting mechanism, and thus an erroneous detection on the thermal chain can be further prevented.

According to the thermal chain detection system 200, the gas discharge passage 50 is coupled to one of the battery modules 10 (cells) in the battery pack 2, and only one pressure sensor 30 is provided downstream of the portion where the gas discharge flow path 50 is coupled to the battery modules. In this way, since the gas discharge passage 50 is coupled to one of the cells, it is not necessary to provide the pressure sensor 30 for each cell, and only one pressure sensor 30 is provided downstream of the coupling portion. That is, the number of members of the thermal chain detection system 200 can be reduced.

According to the thermal chain detection system 200, the battery pack 2 is an open-type battery pack, and the voltage sensors (LBC 41) and the controller 40 (LBC 41 and VCM 42) are provided inside the battery pack 2. In this way, since the voltage sensors (LBC 41) and the controller 40 (LBC 41 and VCM 42) are both provided in the battery pack 2, the thermal chain detection system 200 is made compact.

The cell voltage abnormality determination unit 21B and the pressure abnormality determination unit 22B are provided in the VCM 42 according to the first embodiment and in the LBC 41 according to the second embodiment. Alternatively, the present invention is not limited thereto, and a function distribution in the controller 40, that is, functions distributed to the LBC 41 and the VCM 42 are optional.

Further, although the LBC 41 includes voltage sensors in any of the embodiments, the LBC 41 may be separated from the voltage sensors and transmits the cell voltage V detected by the voltage sensors to the controller 40.

The pressure contributing component that contributes to the pressure change in the battery packs 1 and 2 is the refrigerant gas passage 20 according to the first embodiment and is the gas discharge passage 50 according to the second embodiment. Alternatively, the present invention is not limited thereto, and the pressure contributing component may be any component that contributes to the pressure change in the battery packs 1 and 2. In addition, the gas discharge passage 50 may be further provided in the battery pack 1 and the refrigerant gas passage 20 may be further provided in the battery pack 2.

Although the embodiments of the present invention have been described above, the above-mentioned embodiments are merely a part of application examples of the present invention, and does not mean that the technical scope of the present invention is limited to the specific configurations of the above-mentioned embodiments.

Each of the embodiments described above has been described as a single embodiment, and may be appropriately combined.

## Claims

1. A thermal chain determination method for a battery pack (1), the battery pack (1) including a plurality of cells inside the battery pack (1), a pressure contributing component (20, 50) contributing to a change in a pressure in the battery pack (1), at least one pressure sensor (30) configured to detect the pressure in the battery pack (1), and at least one voltage sensor (41) configured to detect a voltage of the cells, the method comprising:
detecting the pressure in the battery pack (1) by the pressure sensor (30);
detecting the voltage of the cells by the voltage sensor (41);
determining that the pressure in the battery pack (1) is abnormal when an amount of change or a rate of change in the detected pressure in the battery pack (1) is larger than a predetermined value; and
determining that the voltage of the cells is abnormal when an amount of change or a rate of change in the detected voltage of the cells is larger than a predetermined value, or when an absolute value of the voltage of the cells is smaller than a predetermined value;
the method **characterized by** further comprising
determining that a thermal chain occurs when both the pressure in the battery pack (1) and the voltage of the cells are abnormal; and
determining that a thermal chain does not occur when one of the pressure in the battery pack (1) and the voltage of the cells is not abnormal.

2. The thermal chain determination method for a battery pack (1) according to claim 1, wherein
the battery pack (1) includes a plurality of the pressure sensors (30, 30a, 30b); and
the pressure in the battery pack (1) is determined to be abnormal when the amount of change or the rate of change in the pressure in the battery pack (1) detected by at least one of the pressure sensors (30, 30a, 30b) is larger than a predetermined value.

3. The thermal chain determination method for a battery pack (1) according to claim 1 or 2, wherein
the battery pack (1) includes a plurality of the voltage sensors (41) that respectively detect voltages of the different cells; and
the voltage of the cells is determined to be abnormal when the amount of change or the rate of change in the voltage of the cells detected by at least one of the voltage sensors is larger than a predetermined value, or when the absolute value of the voltage of the cells is smaller than a predetermined value.

4. The thermal chain determination method for a battery pack (1) according to any of claims 1 to 3, wherein
a pressure abnormality determination state is continued for a predetermined time even when the amount of change or the rate of change in the pressure in the battery pack (1) becomes equal to or less than the predetermined value after determining that the pressure in the battery pack (1) is abnormal.

5. The thermal chain determination method for a battery pack (1) according to any of claims 1 to 4, wherein
the battery pack (1) includes a battery controller (41) communicable with a vehicle controller (42) outside the battery pack (1); and
the voltage of the cells is determined to be abnormal by regarding the amount of change or the rate of change in the voltage of the cells as larger than the predetermined value, or regarding the absolute value of the voltage of the cells as smaller than the predetermined value in any one of cases where an internal short circuit is detected based on a voltage value detected by the voltage sensor (41), where the voltage value detected by the voltage sensor (41) is an invalid value, or where communication between the battery controller (41) and the vehicle controller (42) is poor.

6. The thermal chain determination method for a battery pack according to any of claims 1 to 5, wherein
the pressure contributing component (20, 50) is at least one of a refrigerant gas passage (20) circulating in the battery pack (1), and a gas discharge passage (50) coupling the cells and the outside of the battery pack (1).

7. A thermal chain detection system for a battery pack (1), the system comprising:
a battery pack (1) housing a plurality of cells;
a pressure contributing component (20, 50) contributing to a change in a pressure in the battery pack (1);
at least one pressure sensor (30, 30a, 30b) configured to detect the pressure in the battery pack (1);
at least one voltage sensor (41) configured to detect a voltage of the cells; and
a controller configured
(i) to determine that the pressure in the battery pack (1) is abnormal when an amount of change or a rate of change in the detected pressure in the battery pack (1) is larger than a predetermined value; and
(ii) to determine that the voltage of the cells is abnormal when an amount of change or an rate of change in the detected voltage of the cells is larger than a predetermined value, or when an absolute value of the voltage of the cells is smaller than a predetermined value;
**characterized in that**
the controller is further configured
(iii) to determine that the thermal chain occurs when both the pressure in the battery pack (1) and the voltage of the cells are abnormal; and
(iv) to determine that a thermal chain does not occur when one of the pressure in the battery pack (1) and the voltage of the cells is not abnormal.

8. The thermal chain detection system for a battery pack (1) according to claim 7, wherein the controller (40) includes:
a battery controller (41) to which at least one of a pressure value detected by the pressure sensor (30) and a voltage value detected by the voltage sensor (41) is input; and
a vehicle controller (42) configured to determine whether the thermal chain occurs; wherein
the battery controller (41) is configured to determine that the voltage of the cells is abnormal by regarding the amount of change or the rate of change in the voltage of the cells as larger than the predetermined value, or regarding the absolute value of the voltage of the cells is smaller than the predetermined value in any one of cases where the battery controller (41) detects an internal short circuit based on the voltage value detected by the voltage sensor (41), where the value of the voltage sensor (41) is an invalid value, or where communication between the battery controller (41) and the vehicle controller (42) is poor.

9. The thermal chain detection system for a battery pack according to claim 7 or 8, wherein
the pressure contributing component (20, 50) is at least one of a refrigerant gas passage (20) circulating in the battery pack, and a gas discharge passage (50) coupling the cells and the outside of the battery pack (1).

10. The thermal chain detection system for a battery pack (1) according to claim 9, wherein
the pressure contributing component (20, 50) includes at least the gas discharge passage (50) coupling the cells and the outside of the battery pack (1); and
the gas discharge passage (50) includes a pressure adjusting mechanism that adjusts the pressure in the gas discharge passage (50).

11. The thermal chain detection system for a battery pack according to claim 9 or 10, wherein
the pressure contributing component (20, 50) includes at least the gas discharge passage (50) coupling the cells and the outside of the battery pack (1);
the gas discharge passage (50) is coupled to one of the cells in the battery pack (1); and
only one pressure sensor (30) is provided downstream of a portion where the gas discharge passage is coupled to the cell.

12. The thermal chain detection system for a battery pack (1) according to any of claims 7 to 11, wherein
the pressure sensor (30, 30a, 30b) is provided at a position where the pressure sensor (30) would not be affected by the thermal chain in the battery pack (1) when the thermal chain occurs in the battery pack (1).

13. The thermal chain detection system for a battery pack (1) according to claim 7, wherein
the controller (40) includes a battery controller (41) to which at least one of a pressure value detected by the pressure sensor (30, 30a, 30b) and a voltage value detected by the voltage sensor (41) is input, and a vehicle controller (42) configured to determine whether the thermal chain occurs;
the voltage sensor (41) is provided in the battery pack (1); and
the vehicle controller (42) is provided outside the battery pack (1).

14. The thermal chain detection system for a battery pack (1) according to any one of claims 7 to 12, wherein
the battery pack (1) is an open-type battery pack; and
the voltage sensor (41) and the controller (40) are provided in the battery pack (1).

## Patentansprüche

1. Verfahren zum Bestimmen einer Wärmekette für einen Batteriepack (1), wobei der Batteriepack (1) eine Vielzahl von Zellen im Inneren des Batteriepacks (1), eine Druckbeitragskomponente (20, 50), die zu einer Änderung des Drucks in dem Batteriepack (1) beiträgt, wenigstens einen Drucksensor (30), der konfiguriert ist zum Erfassen des Drucks in dem Batteriepack (1), und wenigstens einen Spannungssensor (41), der konfiguriert ist zum Erfassen einer Spannung der Zellen, enthält, wobei das Verfahren umfasst:
Erfassen des Drucks in dem Batteriepack (1) durch den Drucksensor (30),
Erfassen der Spannung der Zellen durch den Spannungssensor (41),
Bestimmen, dass der Druck in dem Batteriepack (1) anormal ist, wenn die Änderungsgröße oder die Änderungsrate des erfassten Drucks in dem Batteriepack (1) größer als ein vorbestimmter Wert ist, und
Bestimmen, dass die Spannung der Zellen anormal ist, wenn die Änderungsgröße oder die Änderungsrate der erfassten Spannung der Zellen größer als ein vorbestimmter Wert ist oder wenn der absolute Wert der Spannung der Zellen kleiner als ein vorbestimmter Wert ist,
wobei das Verfahren **dadurch gekennzeichnet ist, dass** es weiterhin aufweist:
Bestimmen, dass eine Wärmekette auftritt, wenn der Druck in dem Batteriepack (1) und die Spannung der Zellen beide anormal sind, und
Bestimmen, dass keine Wärmekette auftritt, wenn der Druck in dem Batteriepack (1) oder die Spannung der Zellen nicht anormal ist.

2. Verfahren zum Bestimmen einer Wärmekette für einen Batteriepack (1) nach Anspruch 1, wobei:
der Batteriepack (1) eine Vielzahl von Drucksensoren (30, 30a, 30b) enthält, und
der Druck in dem Batteriepack (1) als anormal bestimmt wird, wenn die Änderungsgröße oder die Änderungsrate des durch wenigstens einen der Drucksensoren (30, 30a, 30b) erfassten Drucks in dem Batteriepack (1) größer als ein vorbestimmter Wert ist.

3. Verfahren zum Bestimmen einer Wärmekette für einen Batteriepack (1) nach Anspruch 1 oder 2, wobei:
der Batteriepack (1) eine Vielzahl von Spannungssensoren (41), die jeweils Spannungen der verschiedenen Zellen erfassen, enthält, und
die Spannung der Zellen als anormal bestimmt wird, wenn die Änderungsgröße oder die Änderungsrate der durch wenigstens einen der Spannungssensoren erfassten Spannung der Zellen größer als ein vorbestimmter Wert ist oder wenn der absolute Wert der Spannung der Zellen kleiner als ein vorbestimmter Wert ist.

4. Verfahren zum Bestimmen einer Wärmekette für einen Batteriepack (1) nach einem der Ansprüche 1 bis 3, wobei:
ein Druckanormalität-Bestimmungszustand auch dann für eine vorbestimmte Zeit andauert, wenn die Änderungsgröße oder die Änderungsrate des Drucks in dem Batteriepack (1) gleich oder kleiner als der vorbestimmte Wert wird, nachdem bestimmt wurde, dass der Druck in dem Batteriepack (1) anormal ist.

5. Verfahren zum Bestimmen einer Wärmekette für einen Batteriepack (1) nach einem der Ansprüche 1 bis 4, wobei:
der Batteriepack (1) eine Batteriesteuereinrichtung (41), die mit einer Fahrzeugsteuereinrichtung (42) außerhalb des Batteriepacks (1) kommunizieren kann, enthält, und
die Spannung der Zellen als anormal bestimmt wird durch das Bewerten der Änderungsgröße oder der Änderungsrate der Spannung der Zellen als größer als der vorbestimmte Wert oder durch das Bewerten des absoluten Werts der Spannung der Zellen als kleiner als der vorbestimmte Wert in einer Situation, in der ein interner Kurzschluss basierend auf einem durch den Spannungssensor (41) erfassten Spannungswert erfasst wird, der durch den Spannungssensor (41) erfasste Spannungswert ein ungültiger Wert ist oder eine Kommunikation zwischen der Batteriesteuereinrichtung (41) und der Fahrzeugsteuereinrichtung (42) schlecht ist.

6. Verfahren zum Bestimmen einer Wärmekette für einen Batteriepack nach einem der Ansprüche 1 bis 5, wobei:
die Druckbeitragskomponente (20, 50) ein in dem Batteriepack (1) zirkulierender Kühlgasdurchgang (20) und/oder ein die Zellen mit dem Äußeren des Batteriepacks (1) koppelnder Gasausführdurchgang (50) ist.

7. System zum Erfassen einer Wärmekette für einen Batteriepack (1), wobei das System umfasst:
einen Batteriepack (1), in dem eine Vielzahl von Zellen aufgenommen sind,
eine Druckbeitragskomponente (20, 50), die zu einer Änderung des Drucks in dem Batteriepack (1) beiträgt,
wenigstens einen Drucksensor (30, 30a, 30b), der konfiguriert ist zum Erfassen des Drucks in dem Batteriepack (1),
wenigstens einen Spannungssensor (41), der konfiguriert ist zum Erfassen einer Spannung der Zellen, und
eine Steuereinrichtung, die konfiguriert ist zum:
(i) Bestimmen, dass der Druck in dem Batteriepack (1) anormal ist, wenn die Änderungsgröße oder die Änderungsrate des in dem Batteriepack (1) erfassten Drucks größer als ein vorbestimmter Wert ist, und
(ii) Bestimmen, dass die Spannung der Zellen anormal ist, wenn die Änderungsgröße oder die Änderungsrate der erfassten Spannung der Zellen größer als ein vorbestimmter Wert ist oder wenn der absolute Wert der Spannung der Zellen kleiner als ein vorbestimmter Wert ist,
**dadurch gekennzeichnet, dass**
die Steuereinrichtung weiterhin konfiguriert ist zum:
(iii) Bestimmen, dass die Wärmekette auftritt, wenn der Druck in dem Batteriepack (1) und die Spannung der Zellen beide anormal sind, und
(iv) Bestimmen, dass keine Wärmekette auftritt, wenn der Druck in dem Batteriepack (1) oder die Spannung der Zellen nicht anormal ist.

8. System zum Erfassen einer Wärmekette für einen Batteriepack (1) nach Anspruch 7, wobei die Steuereinrichtung (40) enthält:
eine Batteriesteuereinrichtung (41), zu der ein durch den Drucksensor (30) erfasster Druckwert und/oder ein durch den Spannungssensor (41) erfasster Spannungswert eingegeben wird, und
eine Fahrzeugsteuereinrichtung (42), die konfiguriert ist zum Bestimmen, ob die Wärmekette auftritt,
wobei die Batteriesteuereinrichtung (41) konfiguriert ist zum Bestimmen, dass die Spannung der Zellen anormal ist, durch das Bewerten der Änderungsgröße oder der Änderungsrate der Spannung der Zellen als größer als der vorbestimmte Wert oder durch das Bewerten des absoluten Werts der Spannung der Zellen als kleiner als der vorbestimmte Wert in einer Situation, in der die Batteriesteuereinrichtung (41) einen internen Kurzschluss basierend auf dem durch den Spannungssensor (41) erfassten Spannungswert erfasst, der Wert des Spannungssensors (41) ein ungültiger Wert ist oder eine Kommunikation zwischen der Batteriesteuereinrichtung (41) und der Fahrzeugsteuereinrichtung (42) schlecht ist.

9. System zum Erfassen einer Wärmekette für einen Batteriepack nach Anspruch 7 oder 8, wobei:
die Druckbeitragskomponente (20, 50) ein in dem Batteriepack zirkulierender Kühlgasdurchgang (20) und/oder ein die Zellen mit dem Äußeren des Batteriepacks (1) koppelnder Gasausführdurchgang (50) ist.

10. System zum Erfassen einer Wärmekette für einen Batteriepack (1) nach Anspruch 9, wobei:
die Druckbeitragskomponente (20, 50) wenigstens den Gasausführdurchgang (50), der die Zellen mit dem Äußeren des Batteriepacks (1) koppelt, enthält, und
der Gasausführdurchgang (50) einen Druckeinstellungsmechanismus, der den Druck in dem Gasausführdurchgang (50) einstellt, enthält.

11. System zum Erfassen einer Wärmekette für einen Batteriepack nach Anspruch 9 oder 10, wobei:
die Druckbeitragskomponente (20, 50) wenigstens den Gasausführdurchgang (50), der die Zellen mit dem Äußeren des Batteriepacks (1) koppelt, enthält, und
der Gasausführdurchgang (50) mit einer der Zellen in dem Batteriepack (1) gekoppelt ist, und
nur ein Drucksensor (30) stromabwärts von einem Abschnitt, an dem der Gasausführdurchgang mit der Zelle gekoppelt ist, vorgesehen ist.

12. System zum Erfassen einer Wärmekette für einen Batteriepack (1) nach einem der Ansprüche 7 bis 11, wobei:
der Drucksensor (30, 30a, 30b) an einer Position vorgesehen ist, an welcher der Drucksensor (30) nicht durch die Wärmekette in dem Batteriepack (1) beeinflusst wird, wenn die Wärmekette in dem Batteriepack (1) auftritt.

13. System zum Erfassen einer Wärmekette für einen Batteriepack (1) nach Anspruch 7, wobei:
die Steuereinrichtung (40) eine Batteriesteuereinrichtung (41), in die ein durch den Drucksensor (30, 30a, 30b) erfasster Druckwert und/oder ein durch den Spannungssensor (41) erfasster Spannungswert eingegeben wird, und eine Fahrzeugsteuereinrichtung (42), die konfiguriert ist zum Bestimmen, ob die Wärmekette auftritt, enthält,
der Spannungssensor (41) in dem Batteriepack (1) vorgesehen ist, und
die Fahrzeugsteuereinrichtung (42) außerhalb des Batteriepacks (1) vorgesehen ist.

14. System zum Erfassen einer Wärmekette für einen Batteriepack (1) nach einem der Ansprüche 7 bis 12, wobei:
der Batteriepack (1) ein Batteriepack des offenen Typs ist, und
der Spannungssensor (41) und die Steuereinrichtung (40) in dem Batteriepack (1) vorgesehen sind.

## Revendications

1. Procédé de détermination de chaîne thermique pour un bloc de batterie (1), le bloc de batterie (1) incluant une pluralité de cellules à l'intérieur du bloc de batterie (1), un composant contribuant à une pression (20, 50) contribuant à un changement de pression dans le bloc de batterie (1), au moins un capteur de pression (30) configuré pour détecter la pression dans le bloc de batterie (1), et au moins un capteur de tension (41) configuré pour détecter une tension des cellules, le procédé comprenant :
une détection de la pression dans le bloc de batterie (1) par le capteur de pression (30) ;
une détection de la tension des cellules par le capteur de tension (41) ;
une détermination que la pression dans le bloc de batterie (1) est anormale lorsqu'une quantité de modification ou un taux de modification dans la pression détectée dans le bloc de batterie (1) est supérieure à une valeur prédéterminée ; et
une détermination que la tension des cellules est anormale lorsqu'une quantité de modification ou un taux de modification dans la tension détectée des cellules est supérieure à une valeur prédéterminée, ou lorsqu'une valeur absolue de la tension des cellules est inférieure à une valeur prédéterminée ;
le procédé **caractérisé par** ce qu'il comprend en outre
une détermination qu'une chaîne thermique intervient lorsque tant la pression dans le bloc de batterie (1) que la tension des cellules sont anormales ; et
une détermination qu'une chaîne thermique n'intervient pas lorsqu'une de la pression dans le bloc de batterie (1) et de la tension des cellules n'est pas anormale.

2. Le procédé de détermination de chaîne thermique pour un bloc de batterie (1) selon la revendication 1, dans lequel
le bloc de batterie (1) inclut une pluralité de capteurs de pression (30, 30a, 30b) ; et
la pression dans le bloc de batterie (1) est déterminée comme anormale lorsque la quantité de modification ou le taux de modification dans la pression dans le bloc de batterie (1) détectée par au moins un des capteurs de pression (30, 30a, 30b) est supérieure à une valeur prédéterminée.

3. Le procédé de détermination de chaîne thermique pour un bloc de batterie (1) selon la revendication 1 ou 2, dans lequel
le bloc de batterie (1) inclut une pluralité de capteurs de tension (41) qui détectent respectivement des tensions des différentes cellules ; et
la tension des cellules est déterminée comme anormale lorsque la quantité de modification ou le taux de modification dans la tension des cellules par au moins un des capteurs de tension est supérieure à une valeur prédéterminée, ou lorsqu'une valeur absolue de la tension des cellules est inférieure à une valeur prédéterminée.

4. Le procédé de détermination de chaîne thermique pour un bloc de batterie (1) selon l'une quelconque des revendications 1 ou 3, dans lequel
un état de détermination d'anormalité de pression est constant sur une durée prédéterminée même lorsque la quantité de modification ou le taux de modification dans la pression dans le bloc de batterie (1) devient inférieur ou égal à la valeur prédéterminée après une détermination que la pression dans le bloc de batterie (1) est anormale.

5. Le procédé de détermination de chaîne thermique pour un bloc de batterie (1) selon l'une quelconque des revendications 1 ou 4, dans lequel
le bloc de batterie (1) inclut un contrôleur de batterie (41) communicable avec un contrôleur de véhicule (42) hors du bloc de batterie (1) ; et
la tension des cellules est déterminée comme anormale en considérant la quantité de modification ou le taux de modification dans la tension des cellules comme supérieure à la valeur prédéterminée, ou en considérant la valeur absolue de la tension des cellules comme inférieure à la valeur prédéterminée dans un quelconque de cas où un court-circuit interne est détecté selon une valeur de tension détectée par le capteur de tension (41), où la valeur de tension détectée par le capteur de tension (41) est une valeur invalide, ou où une communication entre le contrôleur de batterie (41) et le contrôleur de véhicule (42) est médiocre.

6. Le procédé de détermination de chaîne thermique pour un bloc de batterie selon l'une quelconque des revendications 1 ou 5, dans lequel
le composant contribuant à une pression (20, 50) est au moins un d'un passage de gaz réfrigérant (20) circulant dans le bloc de batterie (1) et d'un passage de décharge de gaz (50) couplant les cellules et l'extérieur du bloc de batterie (1).

7. Système de détection de chaîne thermique pour un bloc de batterie (1), le système comprenant :
un bloc de batterie (1) abritant une pluralité de cellules ;
un composant contribuant à une pression (20, 50) contribuant à un changement dans une pression dans le bloc de batterie (1) ;
au moins un capteur de pression (30, 30a, 30b) configuré pour détecter la pression dans le bloc de batterie (1) ;
et au moins un capteur de tension (41) configuré pour détecter une tension des cellules ; et
un contrôleur configuré
(i) pour déterminer que la pression dans le bloc de batterie (1) est anormale lorsqu'une quantité de modification ou un taux de modification dans la pression détectée dans le bloc de batterie (1) est supérieure à une valeur prédéterminée ; et
(ii) pour déterminer que la tension des cellules est anormale lorsqu'une quantité de modification ou un taux de modification dans la tension détectée des cellules est supérieure à une valeur prédéterminée, ou lorsqu'une valeur absolue de la tension des cellules est inférieure à une valeur prédéterminée ;
**caractérisé en ce que**
le contrôleur est configuré en outre
(iii) pour déterminer que la chaîne thermique intervient lorsque tant la pression dans le bloc de batterie (1) que la tension des cellules sont anormales ; et
(iv) pour déterminer qu'une chaîne thermique n'intervient pas lorsqu'une de la pression dans le bloc de batterie (1) et de la tension des cellules n'est pas anormale.

8. Le système de détection de chaîne thermique pour un bloc de batterie (1) selon la revendication 1, dans lequel
le contrôleur (40) inclut :
un contrôleur de batterie (41) auquel au moins une d'une valeur de pression détectée par le capteur de pression (30) et d'une valeur de tension détectée par le capteur de tension (41) est entrée ; et
un contrôleur de véhicule (42) configuré pour déterminer si la chaîne thermique intervient ou non ; dans lequel
le contrôleur de batterie (41) est configuré pour déterminer que la tension des cellules est anormale en considérant la quantité de modification ou le taux de modification dans la tension des cellules comme supérieure à la valeur prédéterminée, ou en considérant la valeur absolue de la tension des cellules comme inférieure à la valeur prédéterminée dans un quelconque de cas où le contrôleur de batterie (41) détecte un court-circuit interne selon la valeur de tension détectée par le capteur de tension (41), où la valeur du capteur de tension (41) est une valeur invalide, ou où une communication entre le contrôleur de batterie (41) et le contrôleur de véhicule (42) est médiocre.

9. Le système de détection de chaîne thermique pour un bloc de batterie (1) selon la revendication 7 ou 8, dans lequel
le composant contribuant à une pression (20, 50) est au moins un d'un passage de gaz réfrigérant (20) circulant dans le bloc de batterie, et d'un passage de décharge de gaz (50) couplant les cellules et l'extérieur du bloc de batterie (1).

10. Le système de détection de chaîne thermique pour un bloc de batterie (1) selon la revendication 9, dans lequel
le composant contribuant à une pression (20, 50) inclut au moins le passage de décharge de gaz (50) couplant les cellules et l'extérieur du bloc de batterie (1) ; et
le passage de décharge de gaz (50) inclut un mécanisme d'ajustement de pression qui ajuste la pression dans le passage de décharge de gaz (50).

11. Le système de détection de chaîne thermique pour un bloc de batterie selon la revendication 9 ou 10, dans lequel
le composant contribuant à une pression (20, 50) inclut au moins le passage de décharge de gaz (50) couplant les cellules et l'extérieur du bloc de batterie (1) ;
le passage de décharge de gaz (50) est couplé à une des cellules dans le bloc de batterie (1) ; et
un seul capteur de pression (30) est disposé en aval d'une partie où le passage de décharge de gaz est couplé à la cellule.

12. Le système de détection de chaîne thermique pour un bloc de batterie (1) selon l'une quelconque des revendications 7 à 11, dans lequel
le capteur de pression (30, 30a, 30b) est disposé à un emplacement où le capteur de pression (30) ne serait pas affecté par la chaîne thermique dans le bloc de batterie (1) lorsque la chaîne thermique intervient dans le bloc de batterie (1).

13. Le système de détection de chaîne thermique pour un bloc de batterie (1) selon la revendication 7, dans lequel
le contrôleur (40) inclut un contrôleur de batterie (41) auquel au moins une d'une valeur de pression détectée par le capteur de pression (30, 30a, 30b) et d'une valeur de tension détectée par le capteur de tension (41) est entrée, et un contrôleur de véhicule (42) configuré pour déterminer si la chaîne thermique intervient ou non ;
le capteur de tension (41) est disposé dans le bloc de batterie (1) ; et
le contrôleur de véhicule (42) est disposé à l'extérieur du bloc de batterie (1).

14. Le système de détection de chaîne thermique pour un bloc de batterie (1) selon l'une quelconque des revendications 7 à 12, dans lequel
le bloc de batterie (1) est un bloc de batterie de type ouvert ; et
le capteur de tension (41) et le contrôleur (40) sont disposés dans le bloc de batterie (1).
